(19) Europäisches Patentamt
European Patent Office
Office européen des brevets

(11) **EP 1 909 396 A2**

(12) **DEMANDE DE BREVET EUROPEEN**

(43) Date de publication:
**09.04.2008 Bulletin 2008/15**

(51) Int Cl.:
***H03M 13/35*** [(2006.01)]

(21) Numéro de dépôt: **07117639.0**

(22) Date de dépôt: **01.10.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK RS**

(30) Priorité: **03.10.2006 FR 0654059**

(71) Demandeur: **FRANCE TELECOM**
**75015 Paris (FR)**

(72) Inventeurs:
• **POIRRIER, Julien,**
**ILE DE FRANCE FRANCE TELECOM**
**22300, LOCQUEMEAU (FR)**
• **JOINDOT, Michel,**
**ILE DE FRANCE FRANCE TELECOM**
**22300, LANNION (FR)**

(74) Mandataire: **Benetiere, Marion**
**38-40 Avenue du Général Leclerc**
**92794 Issy-les-Moulineaux Cédex 9 (FR)**

(54) **Procédé et dispositif de decodage à l'aide de codes correcteurs d'erreurs**

(57) L'invention concerne un procédé de décodage d'un signal décidé reçu d'un circuit de décision en un signal décodé, ledit procédé comprenant:
- une étape de détection d'un mot de N éléments binaires dans ledit signal décidé reçu, destinée à fournir un mot détecté,
- une étape de sélection d'un mot admissible de N éléments binaires dans un dictionnaire du code correcteur d'erreurs utilisé à l'encodage selon un critère de plus courte distance entre ledit mot détecté et ledit mot admissible sélectionné, et
- une étape de décodage d'un mot de L éléments binaires d'information constituant ledit signal décodé à partir dudit mot admissible sélectionné.

Selon l'invention, la distance mise en oeuvre dans l'étape de sélection prend en compte une fiabilité relative de $2^k$ séquences de K éléments binaires, $0<K<N$.

Fig. 2

**Description**

**1. Domaine de l'invention**

L'invention concerne un procédé de décodage d'un signal décidé reçu d'un circuit de décision en un signal décodé.

L'invention concerne également un décodeur mettant en oeuvre un tel procédé.

L'invention concerne également un dispositif de décodage mettant en oeuvre un tel décodeur.

L'invention concerne également un récepteur mettant en oeuvre un tel dispositif de décodage.

L'invention concerne enfin un programme d'ordinateur mettant en oeuvre un tel procédé lorsqu'il est exécuté par un processeur.

Le domaine de l'invention est celui des réseaux de télécommunications, et plus particulièrement du décodage d'un code correcteur d'erreurs utilisé pour transmettre des informations sur de tels réseaux de télécommunications.

**2. Art antérieur**

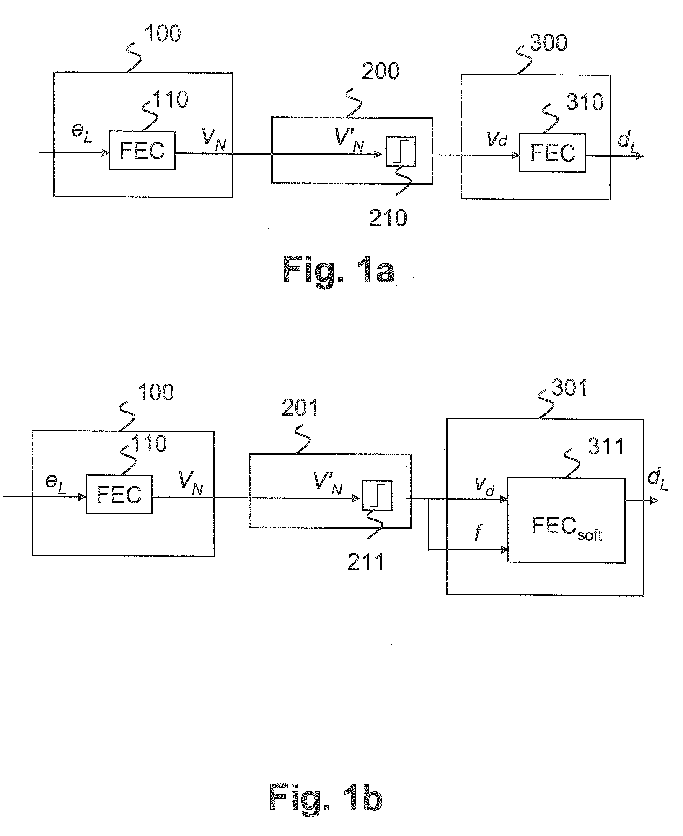

On a représenté, en référence à la Fig. 1a un système de transmission d'un signal dans un réseau de télécommunications mettant en oeuvre un tel code correcteur d'erreurs. Un tel système comprend un émetteur 100 apte à recevoir un signal d'entrée $e_l$ et à émettre un signal encodé $V_N$ sur un canal binaire de transmission 200. L'émetteur 100 comprend un encodeur FEC 110 apte à ajouter une redondance au signal d'entrée $e_l$ de la façon suivante : on considère que le signal d'entrée $e_l$ est formé d'une suite de mots de L éléments binaires, 0<L<N, appelés mots utiles ou mots d'information, puisque ces L éléments binaires constituent l'information à transmettre sur le canal. Le principe du code correcteur d'erreurs consiste à associer à un mot utile un mot de N éléments binaires, où N est un entier supérieur à L. Le signal $w_N$ est émis sur le canal binaire 200. Un signal $V'_N$ est reçu par un circuit de décision 210, qui détecte l'information transportée sur le canal et traduit le résultat de la décision sous forme d'un signal binaire décidé $V_d$. Ce signal binaire décidé est reçu par un récepteur 300 comprenant un décodeur FEC 310 apte à fournir un signal décodé $d_l$ à partir du signal décidé $V_d$. Le décodeur FEC 310 utilise l'information redondante contenue dans les N-L éléments binaires pour retrouver le mot utile émis de la façon suivante : parmi tous les mots de N éléments binaires possibles, seuls certains sont admissibles. Ces mots admissibles, appelés mots de code, font partie d'un dictionnaire caractéristique du code correcteur d'erreurs considéré. Cette restriction permet non seulement de reconnaître un mot de N éléments binaires n'appartenant pas à la famille des mots possibles du code correcteur d'erreurs, mais aussi de détecter et éventuellement de corriger des erreurs de transmission. Le décodeur FEC 310 sélectionne le mot de N éléments binaires le plus vraisemblable conditionnellement au signal décidé $V_{Nd}$ qui a été détecté et émet le mot de L éléments binaires qui lui correspond. On peut montrer que c'est équivalent à décider que le mot de N éléments binaires $W_N$ émis est le mot du code correcteur d'erreurs le plus proche du mot $V_{Nd}$ qui a été décidé sur l'ensemble des mots de N éléments binaires (c'est-à-dire sur l'ensemble **[0,1]**$^N$), au sens d'une distance appelée distance de Hamming, qui est définie comme suit:

$$d\left(V_{Nd},W\right) = \sum_{i=1}^{N} \delta_{v_i w_i} = \mathrm{card}(v_i|v_i \neq w_i) = \mathrm{card}(w_i|w_i \neq v_i) = d\left(W,V_{Nd}\right)$$

La distance entre deux mots est calculée comme le cardinal de l'ensemble des éléments binaires sur lesquels ils diffèrent. Par exemple, la distance entre les deux mots de 5 éléments binaires (1,0,0,1,0) et (1,1,1,0,0) est 3. La distance entre deux mots est une mesure quantitative de leur ressemblance : plus ils sont proches, plus ils ont d'éléments binaires communs, donc plus ils se ressemblent. On peut donc dire que le décodeur choisit le mot du code qui ressemble le plus au mot détecté.

La capacité de correction d'erreurs du code est liée à la distance minimale entre deux mots du code.

La distance entre le mot de code W et le mot $V_{Nd}$ peut être aussi interprétée comme le nombre de décisions erronées qui se sont produites et ont conduit à choisir $V_{Nd}$ alors que W avait été émis.

Le mécanisme de décodage des codes correcteurs d'erreurs se base sur l'hypothèse d'un canal binaire symétrique, c'est-à-dire d'un canal où les probabilités conditionnelles sont égales. Plus précisément, on entend par canal binaire symétrique un canal transmettant l'information sous la forme d'éléments binaires [0,1] pour lequel la probabilité de décider un 0 quand un 1 a été émis est égale à celle de décider un 0 quand un 1 a été émis. Ceci se traduit par l'égalité des probabilités d'erreurs conditionnelles: $p(0/1)=p(1/0)$.

Le mécanisme de décodage des codes correcteurs d'erreurs qui a été exposé est optimal sous cette hypothèse, qui est tout-à-fait valable pour la majorité des systèmes de communications où le bruit dominant est généralement additif, indépendant du signal et où le seuil de décision est positionné de manière optimale, soit naturellement dans le cas de signaux à moyenne nulle, soit par un dispositif adaptatif.

Il existe cependant des applications qui, pour des raisons de bruit ou de mémoire du canal ne satisfont pas cette hypothèse. Le fonctionnement des codes correcteurs d'erreurs est alors sous-optimal. C'est le cas, par exemple, des réseaux optiques passifs (Passive Optical Networks (PON) en anglais) dont le canal utilise un seuil de décision non optimal. C'est le cas également des réseaux de télécommunication dont le canal présente une forte interférence entre symboles, ce qui conduit à une plus forte probabilité d'erreur de certaines séquences.

Le document intitulé "Next Generation FEC ("Forward Error Coding") for Optical Transmission Systems" par T. Mizuochi *et al.* divulgue une technique de décodage doux, de l'anglais "Soft decoding", qui s'applique au circuit de décision, en amont du décodeur de code correcteur d'erreurs, et permet de délivrer bit à bit et instantanément une fiabilité d'une séquence d'éléments binaires et de la prendre en compte dans sa décision concernant un bit courant. La fiabilité est représentative de la confiance qui est attachée à une décision, et le décodage doux revient à "pondérer" une décision par la confiance que l'on peut mettre en elle.

On a représenté, en référence à la Fig. 1b, un système de transmission de données sur un réseau de télécommunication mettant en oeuvre la technique de décodage doux selon cet art antérieur. Le circuit de décision 211 est apte à fournir, en plus d'une décision sur l'élément binaire reçu, une fiabilité f évaluée pour cet élément binaire à un dispositif de décodage 301 comprenant un décodeur de code correcteur d'erreurs 311. Un tel décodeur 311, appelé aussi décodeur doux, est apte à intégrer les fiabilités des éléments binaires présents dans le signal décidé reçu pour sélectionner le mot possible le plus vraisemblable dans son dictionnaire caractéristique du code correcteur d'erreurs considéré.

### 3. Inconvénients de l'art antérieur

Un premier inconvénient de cette technique est que le circuit de décision ainsi modifié se trouve extrêmement complexifié et qu'il devient difficile et coûteux à réaliser.

Un deuxième inconvénient est que, dans le domaine des réseaux d'accès en particulier, les circuits de décision qui sont mis en oeuvre sont très primaires et ne peuvent pas implémenter une telle complexité.

L'invention a notamment pour objectif de pallier ces inconvénients de l'art antérieur.

Plus précisément, il existe un besoin d'une solution pour compenser la dissymétrie du canal de transmission au niveau du décodeur sans complexifier le circuit de décision du récepteur.

L'invention répond à ce besoin à l'aide d'un procédé de décodage d'un signal décidé reçu d'un circuit de décision en un signal décodé, ledit procédé comprenant :

- une étape de détection d'un mot de N éléments binaires dans ledit signal décidé reçu,
- une étape de sélection d'un mot admissible de N éléments binaires d'information dans un dictionnaire du code correcteur d'erreurs mis en oeuvre à l'encodage selon un critère de plus courte distance entre ledit mot détecté et ledit mot admissible sélectionné,
- une étape de décodage d'un mot de L éléments binaires d'information constituant ledit signal décodé à partir dudit mot admissible sélectionné.

Le procédé selon l'invention est particulier en ce que la distance mise en oeuvre dans l'étape de sélection prend en compte des fiabilités relatives de $2^K$ séquences de K éléments binaires, $0<K<N$.

Ainsi, l'invention repose sur une approche tout à fait nouvelle et inventive du décodage d'un code correcteur d'erreurs. En effet, l'invention propose de prendre en compte la fiabilité relative d'une séquence d'éléments binaires d'information dans le processus de décodage du signal décidé en signal décodé.

L'invention permet ainsi de résoudre le problème technique de l'augmentation de la capacité de correction du code correcteur d'erreurs dans le cas d'un canal binaire dissymétrique sans complexifier le circuit de décision. Le procédé selon l'invention permet également d'améliorer les performances du code correcteur d'erreurs tout en restant indépendant du processus de décision

Un tel procédé de décodage met en oeuvre la fiabilité relative d'un élément binaire ou d'une séquence d'éléments binaires par rapport aux autres éléments binaires ou séquences d'éléments binaires possibles. A la différence du décodage doux selon l'art antérieur, il ne recalcule pas une nouvelle valeur de fiabilité pour chaque nouvel élément binaire considéré. Ceci permet de limiter la complexité du procédé de décodage dans son ensemble.

Selon un aspect de l'invention, ladite distance est une somme pondérée de $2^K$ cardinaux, dans lequel le $i^{ème}$ cardinal, $0 \leq i \leq 2^K -1$, des occurrences de la $i^{ème}$ séquence de K éléments binaires d'information dans le mot détecté, telles que le $k^{ème}$ élément binaire, $0 \leq k \leq K -1$, diffère du $k^{ème}$ élément binaire dans le mot admissible sélectionné, est pondéré par un $i^{ème}$ coefficient de fiabilité de ladite $i^{ème}$ séquence de K éléments binaires. La distance obtenue se distingue des distances classiquement utilisées pour sélectionner le mot possible le plus proche en ce qu'elle sépare les occurrences des différentes séquences d'éléments binaires. En effet, alors qu'une distance classique se calcule comme le cardinal de toutes les occurrences de séquences d'éléments binaires qui diffèrent entre le mot possible et le signal décidé, la distance selon l'invention se calcule en considérant les cardinaux de chaque séquence d'éléments binaires individuellement et en leur affectant des coefficients de fiabilité relative attitrés. Ceci permet donc de compenser la dissymétrie du canal binaire.

Selon un autre aspect de l'invention, lesdits coefficients de fiabilité sont déterminés au préalable. L'invention permet alors de compenser de façon très simple une dissymétrie du canal binaire de transmission.

Selon encore un autre aspect de l'invention, le procédé de décodage comprend :

- une étape de suppression d'une séquence de N-L éléments binaires redondants dans le mot détecté, 0<L<N, destinée à fournir un mot détecté utile, constitué d'éléments binaires d'information,
- une première étape de comptage d'un $i^{ème}$ nombre d'occurrences $No_i$ de la $i^{ème}$ séquence $S_i$, $0 \leq i \leq 2^K$ -1 de K éléments binaires d'information dans les mots détectés utiles pendant un intervalle de temps T déterminé, et
- une première étape d'évaluation dudit $i^{ème}$ coefficient de fiabilité $c_i$ de la $i^{ème}$ séquence de K éléments binaires $S_i$ à partir dudit $i^{ème}$ nombre d'occurrences $No_i$.

Ainsi les coefficients de fiabilité sont évalués à partir d'une statistique des signaux décidés reçus. L'invention permet alors d'adapter la distance utilisée par l'étape de sélection dans le temps.

Selon un autre aspect de l'invention, le procédé de décodage comprend :

- une étape de suppression d'une séquence de N-L éléments binaires redondants dans le mot détecté, 0<L<N, destinée à fournir un mot détecté utile constitué d'éléments binaires d'information,
- une seconde étape de comptage d'un $i^{ème}$ cardinal d'occurrences $No'_i$ de la séquence $S_i$, $0 \leq i \leq 2^K$ -1, de K éléments binaires, $0 \leq k \leq K - 1$, dans les mots détectés utiles pendant un intervalle de temps T déterminé, telles que le $k^{ème}$ élément binaire diffère de celui de la séquence correspondante dans le signal décodé, et
- une seconde étape d'évaluation dudit $i^{ème}$ coefficient de fiabilité $c'_i$ de la $i^{ème}$ séquence de K éléments binaires $S_i$ à partir dudit $i^{ème}$ nombre d'occurrences $No'_i$.

Ainsi, les coefficients de fiabilité relative sont évalués par comparaison des signaux décodés et décidés, en comptabilisant les occurrences des séquences d'éléments binaires qui diffèrent entre le signal décodé et le mot détecté dans le signal décidé. L'invention permet alors d'adapter la distance utilisée par l'étape de sélection pour les prochains signaux décidés en fonction des signaux décodés obtenus précédemment.

Préférentiellement, lesdites étapes de comptage et d'évaluation sont répétées régulièrement dans le temps, de façon à garantir une bonne adaptation de la distance à l'état du canal binaire.

Selon un autre aspect de l'invention, le procédé de décodage comprend :

- une deuxième étape de sélection d'un mot admissible intermédiaire comprenant N éléments binaires dans ledit dictionnaire de codes correcteurs d'erreurs selon un critère de plus courte distance entre ledit mot détecté et ledit mot admissible intermédiaire, à partir d'une seconde distance égale au cardinal des occurrences de séquences de K éléments binaires $S_i$ présentes dans le signal décidé, $0 \leq i \leq 2^K$ -1, telles que le $k^{ème}$ élément binaire diffère de celui de la séquence correspondante dans le mot admissible intermédiaire,
- une deuxième étape de décodage d'un mot de K éléments binaires constituant un signal décodé intermédiaire à partir dudit mot admissible intermédiaire,

ledit signal décodé intermédiaire étant destiné à être fourni à ladite seconde étape de comptage.

Cette deuxième étape de sélection utilise donc une distance classique qui n'est pas pondérée par des coefficients de fiabilité. Le signal décodé qu'elle fournit est utilisé par la seconde étape d'évaluation pour calculer les coefficients de fiabilité à appliquer au mot détecté dans le signal décidé. Ceci permet alors de garantir que la distance mise en oeuvre dans l'étape de sélection est bien adaptée sans retard au signal décidé qui vient d'être reçu.

L'invention concerne aussi un décodeur d'un signal décidé reçu d'un circuit de décision en un signal décodé, ledit décodeur comprenant :

- des moyens de détection d'un mot de N éléments binaires dans ledit signal décidé reçu, aptes à fournir un mot détecté,
- des moyens de sélection d'un mot admissible de N éléments binaires dans un dictionnaire du code correcteur d'erreurs utilisé à l'encodage selon un critère de plus courte distance entre ledit mot détecté et ledit mot admissible sélectionné, et
- des moyens de décodage d'un mot de L éléments binaires constituant ledit signal décodé à partir dudit mot admissible sélectionné.

Un tel dispositif est particulier en ce que la distance mise en oeuvre par lesdits moyens de sélection est adaptée pour prendre en compte des fiabilités relatives de $2^K$ séquences de K éléments binaires, 0<K<N.

L'invention concerne également un dispositif de décodage comprenant ledit décodeur, ledit décodeur comprenant des moyens de suppression d'une séquence de N-L éléments binaires redondants dans le mot détecté, destinée à fournir un mot détecté utile.

Ledit dispositif de décodage est particulier en ce qu'il comprend :

- des seconds moyens de comptage d'un $i^{ème}$ nombre d'occurrences $No'_i$ de la $i^{ème}$ séquence de K éléments binaires $S_k$ dans le mot détecté utile, $0 \leq i \leq 2^K - 1$, telles que le $k^{ème}$ élément binaire diffère de celui de la séquence correspondante du signal décodé, et
- des seconds moyens d'évaluation dudit $i^{ème}$ coefficient de fiabilité $c'_i$ de la $i^{ème}$ séquence de K éléments binaires $S_k$ à partir dudit $i^{ème}$ nombre d'occurrences $No'_i$.

L'invention concerne également un dispositif de décodage, comprenant un deuxième décodeur apte à décoder le signal décidé en un signal décodé intermédiaire, ledit signal décodé intermédiaire étant destiné à être fourni aux seconds moyens de comptage.

L'invention concerne également un récepteur comprenant un circuit de décision apte à fournir un signal décidé à partir d'un signal transmis et un décodeur apte à décoder ledit signal décidé ($V_d$), ledit décodeur comprenant :

- des moyens de détection d'un mot de N éléments binaires dans ledit signal décidé reçu, aptes à fournir un mot détecté,
- des moyens de sélection d'un mot admissible de N éléments binaires dans un dictionnaire de codes correcteurs d'erreurs selon un critère de plus courte distance entre ledit mot détecté et ledit mot admissible sélectionné, et
- des moyens de décodage d'un mot de L éléments binaires constituant ledit signal décodé à partir dudit mot admissible sélectionné.

Ledit récepteur est particulier en ce que la distance mise en oeuvre par lesdits moyens de sélection est adaptée pour prendre en compte des fiabilités relatives de $2^K$ séquences de K éléments binaires, 0<K<N.

L'invention concerne enfin un produit programme d'ordinateur téléchargeable depuis un réseau de communication et/ou stocké sur un support lisible par ordinateur et/ou exécutable par un microprocesseur.

Un tel produit programme d'ordinateur est particulier en ce qu'il comprend des instructions de code de programme pour l'exécution du procédé de décodage selon l'invention, lorsqu'il est exécuté sur un ordinateur.

## 4. **Liste des figures**

D'autres avantages et caractéristiques de l'invention apparaîtront plus clairement à la lecture de la description suivante d'un mode de réalisation particulier de l'invention, donné à titre de simple exemple illustratif et non limitatif, et des dessins annexés, parmi lesquels :

- la figure 1a présente un schéma synoptique illustrant la structure de fonctionnement d'une chaîne d'encodage, de transmission et de décodage selon l'art antérieur;
- la figure 1b illustre la technique de décodage doux mise en oeuvre par le circuit de décision selon l'art antérieur;
- la figure 2 présente un diagramme fonctionnel du procédé de décodage selon un premier mode de réalisation de l'invention;
- la figure 3 présente un diagramme fonctionnel du procédé de décodage selon un deuxième mode de réalisation de l'invention;
- la figure 4 présente un diagramme fonctionnel du procédé de décodage selon un troisième mode de réalisation de l'invention;
- la figure 5 présente un diagramme fonctionnel du procédé de décodage selon un quatrième mode de réalisation de l'invention;
- la figure 6a présente un schéma synoptique illustrant la structure de fonctionnement d'un dispositif de décodage selon un premier mode de réalisation de l'invention;
- la figure 6b présente un schéma synoptique illustrant la structure de fonctionnement d'un dispositif de décodage selon un deuxième mode de réalisation de l'invention;
- la figure 7a présente un schéma synoptique illustrant la structure de fonctionnement d'un dispositif de décodage selon un troisième mode de réalisation de l'invention;
- la figure 7b présente un schéma synoptique illustrant la structure de fonctionnement d'un dispositif de décodage selon un quatrième mode de réalisation de l'invention;
- la figure 8 présente une série de courbes permettant de comparer les variations de performances de dispositifs de décodage selon l'invention et selon l'art antérieur en fonction du taux d'erreur d'entrée dans le dispositif de décodage.

## 5. Description d'un mode de réalisation particulier de l'invention

Le principe général de l'invention repose sur l'utilisation par le décodeur de codes correcteurs d'erreurs ou décodeur FEC, acronyme anglais de "Forward Error Correction Coding", d'une pseudo-distance qui distingue les erreurs se produisant pour des séquences de K éléments binaires et attribue à ces erreurs des fiabilités relatives. La théorie des codes correcteurs d'erreurs, connue de l'homme de métier, est par exemple exposée dans l'ouvrage intitulé "Introduction to Coding Theory" par Ron Roth, Cambridge, ISBN-13: 9780521845045 | ISBN-10: 0521845041.

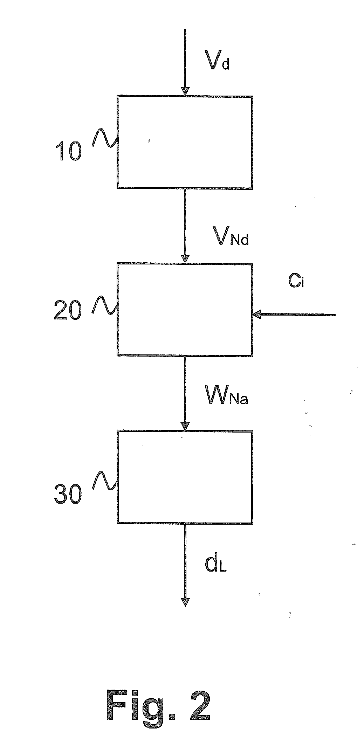

En référence à la Figure 2, on a représenté un diagramme fonctionnel du procédé de décodage selon l'invention. Un tel procédé comprend:

- une étape 10 de détection d'un mot $V_{Nd}$ de N éléments binaires dans un signal $V_d$ décidé reçu,
- une étape 20 de sélection d'un mot admissible $W_{Na}$ de N éléments binaires dans un dictionnaire de codes correcteurs d'erreurs selon un critère de plus courte distance entre ledit mot détecté et ledit mot admissible sélectionné,
- une étape 30 de décodage d'un mot $d_L$ de L éléments binaires constituant partie du signal décodé à partir dudit mot admissible sélectionné $W_{Na}$.

Selon un aspect de l'invention, le critère de plus courte distance mis en oeuvre par l'étape de sélection 20 est satisfait à l'aide d'une pseudo-distance d, calculée comme la somme pondérée des cardinaux des erreurs qui se sont produites dans le mot détecté sur le $k^{ème}$ élément binaire d'une séquence d'éléments binaires par un coefficient de fiabilité relatif à cette séquence d'éléments binaires particulière.

Dans ce qui suit, on considérera d'abord, pour des raisons de simplicité, le cas des éléments binaires isolés, c'est-à-dire que la pseudo-distance selon l'invention distingue parmi les erreurs sur les "0" et les erreurs sur les "1" entre le mot de N éléments binaires détectés dans le signal décidé $V_{Nd}$ et le mot admissible $W_{Na}$ du dictionnaire du code correcteur d'erreur utilisé par le décodeur FEC. On généralisera ensuite au cas de $2^K$ séquences de K éléments binaires.

Dans le cas simple où l'on considère les éléments binaires isolément, la pseudo-distance à calculer entre le mot détecté et chacun des mots admissibles appartenant au dictionnaire du code correcteur d'erreurs n'est plus alors le cardinal des éléments binaires qui diffèrent, mais la somme pondérée du cardinal des zéros et du cardinal des uns du mot détecté qui diffèrent du mot admissible.

La pseudo-distance $\widetilde{d}$ selon l'invention peut, par exemple, s'exprimer selon l'équation suivante :

$$\widetilde{d}\left(V_{Nd},W_{Na}\right) = c_0 \text{ card}_{0 \leq i < N}\left(v_i \middle| v_i \neq w_i, w_i = 0\right) + c_1 \text{card}\left(v_i \middle| v_i \neq w_i, w_i = 1\right)$$
$$\neq \widetilde{d}\left(W_{Na},V_{Nd}\right)$$

où $v_i$ est le $i^{ème}$ bit du mot détecté $V_{Nd}$ et $w^i$ le $i^{ème}$ bit du mot admissible $W_{Na}$.

Les coefficients de pondération sont les coefficients de fiabilité $c_0$ et $c_1$ de l'élément binaire 0 et de l'élément binaire 1 respectivement. Ces coefficients sont fonction de la fiabilité relative des 0 et des 1. Ils peuvent typiquement être pris comme - ln($p$(0/1)) et -ln($p$(1/0)), ln étant le logarithme népérien.

Cette fonction n'étant plus symétrique, il ne s'agit plus d'une distance, mais de ce que nous appellerons une "pseudo-distance", que nous distinguerons d'une distance classique en ajoutant un ~.

A titre d'exemple, considérons par exemple les deux mots de longueur 6 $W_{Na}$=(0,1,1,0,1,0) et $V_{Nd}$=(1,0,1,1,0,1). Leur distance de Hamming est 5. La pseudo-distance de la relation précédente est $3c_0+2c_1$.

Dans le cas plus complexe où l'on considère l'élément binaire central d'une séquence xyz de 3 éléments binaires, la pseudo-distance $d_y$ selon cet aspect de l'invention est définie comme suit :

$$d_y(V_{Nd},W_{Na}) = \sum_{i=0}^{2^3-1} c_i.card(x\overline{y}z)$$

En d'autres termes, la pseudo-distance s'exprime alors comme la somme pondérée des cardinaux des occurrences des 8 séquences xyz possibles, pour lesquelles l'élément central diffère dans le mot détecté $V_{Nd}$ par rapport au mot admissible $W_a$.

Dans le cas général où l'on considère $2^K$ séquences de K éléments binaires, 0<K<N, la pseudo-distance peut s'exprimer de la façon suivante :

$$d_{x_0}(V_{Nd}, W_{Na}) = \sum_{i=0}^{2^{m+r+1}-1} c_i . card(x_{-m} \ldots x_{-1} \overline{x_0} x_1 \ldots x_r) \, ,$$

où $x_{-m} \ldots x_0 x_1 \ldots x_r$ est une séquence de K éléments binaires, $0<m<K$ et $0<r<K$ et l'élément binaire $x_0$ appartient à $V_{Nd}$. Selon une telle distance, on considère la somme pondérée des cardinaux des occurrences des $2^K$ séquences possibles pour lesquelles le kème élément binaire $x_0$ diffère dans le mot détecté $V_{Nd}$ par rapport au mot admissible $W_{Na}$. Il s'agit par exemple de l'élément central ou de tout autre élément de la séquence qui appartient au mot détecté $V_{Nd}$.

Pour calculer cette pseudo-distance, il est nécessaire de garder en mémoire un contexte comprenant les m éléments binaires décidés qui précèdent et les r éléments binaires décidés qui suivent le mot détecté $V_{Nd}$.

Selon un premier mode de réalisation de l'invention, les coefficients de fiabilité $\{c_i\}$ sont déterminés au préalable. Pour être efficace, cette solution nécessite une connaissance a priori suffisante du canal de transmission et une stabilité de la statistique de ce canal au cours du temps.

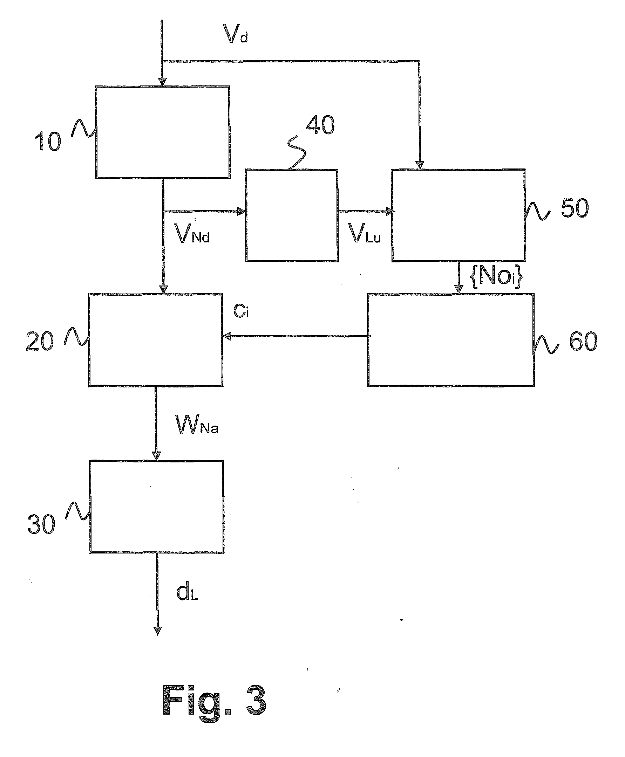

En référence à la Fig. 3, on présente un diagramme fonctionnel du procédé de décodage selon un deuxième mode de réalisation de l'invention. Le procédé comprend en plus des étapes de sélection 10, détection 20 et décodage 30:

- une étape 40 de suppression d'une séquence de N-L éléments binaires redondants dans le mot détecté $V_{Nd}$, $0<L<N$, destinée à fournir un mot d'éléments binaires d'information utile $V_{Lu}$
- une première étape de comptage 50 d'un ième nombre d'occurrences $No_i$ de la ième séquence $S_i$, $0 \le i \le 2^K -1$ de K éléments binaires dans les mots détectés utiles $\{V_{Lu}(t)\}$ pendant un intervalle de temps T déterminé, et
- une première étape 60 d'évaluation dudit ième coefficient de fiabilité $c_i$ de la ième séquence de K éléments binaires $S_i$ à partir dudit ième nombre d'occurrences $No_i$.

Dans le cas simple où la séquence d'éléments binaires ne comprend qu'un seul élément, la première étape de comptage 50 revient à compter le nombre de "1" et le nombre de "0" décidés.

Dans le cas plus complexe d'une séquence d'éléments binaires comprenant plus d'un élément binaire, par exemple une séquence *xyz* de trois éléments binaires, la première étape de comptage 50 revient à compter le nombre d'occurrences de la séquence *xyz* dans le signal décidé pendant la période de temps T.

La première étape 60 d'évaluation des coefficients de fiabilité consiste ensuite à évaluer les coefficients $c_i$ en normalisant les nombres d'occurrences $No_i$ obtenus, par exemple, de la façon suivante :

$$c_i = (1 - C^{st} \cdot \frac{No_i}{\sum_{j=0}^{2^K-1} No_j})$$

où Cst est une constante.

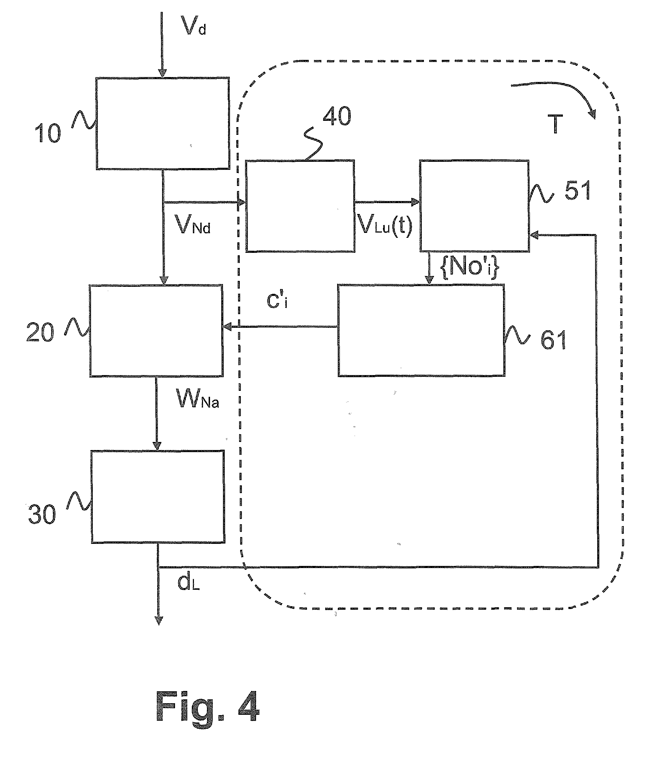

En référence à la Fig. 4, on présente un diagramme fonctionnel du procédé de décodage selon un troisième mode de réalisation de l'invention. Le procédé comprend en plus des étapes de sélection 10, détection 20 et décodage 30:

- l'étape 40 de suppression d'une séquence de N-L éléments binaires redondants dans le mot détecté $V_{Nd}$, destinée à fournir un mot détecté utile $V_{Lu}$,
- une seconde étape 51 de comptage d'un ième cardinal d'occurrences $No'_i$ de la séquence $S_i$, $0 \le i \le 2^K -1$, de K éléments binaires dans les mots détectés utiles $\{V_{Lu}(t)\}$ pendant un intervalle de temps T déterminé, telles que le kème élément binaire diffère de celui de la séquence correspondante dans le signal décodé $V_{Nd}$, et
- une seconde étape 61 d'évaluation dudit ième coefficient de fiabilité $c'_i$ de la ième séquence de K éléments binaires $S_i$ à partir dudit ième nombre d'occurrences $No'_i$.

Dans le cas simple où la séquence d'éléments binaires ne comprend qu'un seul élément, la seconde étape de comptage 51 revient à compter le nombre de 1 et le nombre de 0 décidés qui diffèrent de ceux du signal décodé.

La seconde étape d'évaluation 61 évalue ensuite les coefficients de fiabilité $c_i$, par exemple d'une façon similaire à celle décrite dans le mode de réalisation précédent:

$$\cdot c_i = (1 - C^{st} \cdot \frac{No'_i}{\sum_{j=0}^{2^K-1} No'_j})$$

Selon une variante, la seconde étape d'évaluation 61 évalue des probabilités conditionnelles p(0/1) et p(1/0) de la façon suivante:

$$p(0/1) = \frac{No'_0}{\mathrm{card}_{d_L}(1)} \; ,$$

où $\mathrm{card}_{d_L}(1)$ représente le cardinal des éléments binaires 1 présents dans le signal décodé;

$$p(1/0) = \frac{No'_1}{\mathrm{card}_{d_L}(0)} \; ,$$

où $\mathrm{card}_{d_L}(0)$ représente le cardinal des éléments binaires 0 présents dans le signal décodé;
Les coefficients de fiabilité $c_i$ sont ensuite dérivés de façon valide en appliquant à ces probabilités conditionnelle une fonction de type logarithme népérien:

$$c_0 = -\ln(p(0/1))$$

$$c_1 = -\ln(p(1/0))\cdot$$

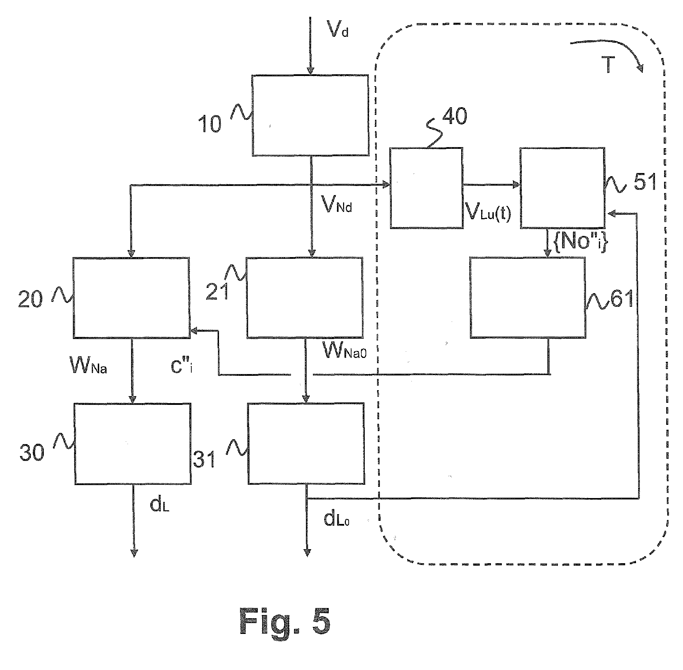

Dans le cas plus complexe d'une séquence d'éléments binaires comprenant plus d'un élément binaire, par exemple une séquence *xyz* de trois éléments binaires, la seconde étape de comptage 51 revient à compter, pendant la période de temps T, le nombre d'occurrences $No'_i$ de la séquence $x\overline{y}z$ dans le signal décidé, alors que la $i^{ème}$ séquence *xyz* est présente dans le signal décodé.
La seconde étape d'évaluation 61 évalue ensuite les coefficients de fiabilité $c_i$, par exemple d'une façon similaire à celle décrite dans le cas simple.
Ce mode de réalisation permet d'extraire les coefficients de fiabilité de statistiques d'erreur du décodeur FEC évaluées sur une période de temps T.
En référence à la Fig. 5, on présente un diagramme fonctionnel du procédé de décodage selon un quatrième mode de réalisation de l'invention. Le procédé comprend en plus des étapes de sélection 10, détection 20, décodage 30, suppression 40, comptage 50, 51 et évaluation 60, 61 :

- une deuxième étape 21 de sélection d'un mot admissible intermédiaire $W_{Na0}$ comprenant N éléments binaires dans ledit dictionnaire de codes correcteurs d'erreurs selon un critère de plus courte distance entre ledit mot détecté $V_{Nd}$ et ledit mot admissible intermédiaire $W_{Na0}$, à partir d'une seconde distance égale au cardinal des occurrences de séquences de K éléments binaires $S_i$ présentes dans le signal décidé, $0 \leq i \leq 2^K - 1$, telles que le $k^{ème}$ élément binaire diffère de celui de la séquence correspondante dans le mot admissible intermédiaire $W_{Na0}$,
- une deuxième étape de décodage 31 d'un mot de L éléments binaires constituant un signal décodé intermédiaire $d_{L0}$ à partir dudit mot admissible intermédiaire $W_{Na0}$, ledit signal décodé intermédiaire étant destiné à être fourni à la seconde étape de comptage 51.

Ce mode de réalisation permet d'extraire des statistiques d'erreur d'un deuxième décodeur FEC mettant en oeuvre une distance classique. Si le signal n'est pas trop dégradé, ces statistiques estiment $p(0/1)$ et $p(1/0)$ dans le cas simple où la séquence d'éléments binaires ne comprend qu'un seul élément, et la probabilité $p(\overline{y}/xyz)$ dans le cas d'une séquence d'éléments binaires comprenant plus d'un élément binaire, par exemple une séquence *xyz* de trois éléments binaires.

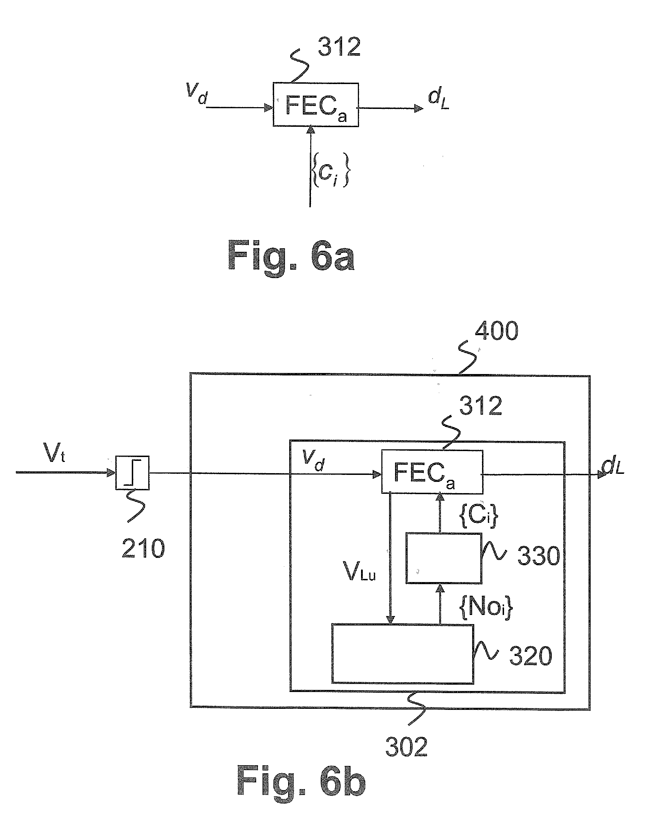

En référence à la Fig. 6a, on présente un décodeur FEC$_a$ 312 selon un premier mode de réalisation de l'invention. Un tel décodeur comprend :

- des moyens de détection d'un mot de N éléments binaires dans ledit signal décidé reçu, aptes à fournir un mot détecté,
- des moyens de sélection d'un mot admissible de N éléments binaires dans un dictionnaire de codes correcteurs d'erreurs selon un critère de plus courte distance entre ledit mot détecté et ledit mot admissible sélectionné, et
- des moyens de décodage d'un mot de L éléments binaires constituant ledit signal décodé à partir dudit mot admissible sélectionné.

Pour des raisons de clarté, ces moyens ne sont pas représentés sur la Fig. 6a. Selon l'invention, la distance mise en oeuvre par lesdits moyens de sélection est adaptée pour prendre en compte des fiabilités relatives de $2^K$ séquences de K éléments binaires, 0<K<N. Selon un premier aspect de l'invention, il s'agit d'une pseudo-distance qui estime une somme pondérée de $2^K$ cardinaux, le $i^{ème}$ cardinal, $0 \leq i \leq 2^K$ -1, comptabilisant des occurrences de la $i^{ème}$ séquence de K éléments binaires dans le signal décidé, telles que le $k^{ème}$ élément binaire, $0 \leq i \leq K$ -1, diffère du $k^{ème}$ élément binaire dans le signal décodé, par un $i^{ème}$ coefficient de fiabilité de ladite $i^{ème}$ séquence de K éléments binaires.

Selon un premier mode de réalisation de l'invention, les coefficients de fiabilité sont déterminés au préalable.

En référence à la Fig. 6b, on présente un récepteur 400 comprenant un dispositif de décodage 302 selon un deuxième mode de réalisation de l'invention. Un tel dispositif de décodage comprend :

- le décodeur FEC$_a$, 312,
- des premiers moyens de comptage 320 d'un $i^{ème}$ nombre d'occurrences No$_i$ de la $i^{ème}$ séquence de K éléments binaires S$_i$ dans les signaux décidés pendant un intervalle de temps déterminé, $0 \leq i \leq 2^K$ -1, et
- des premiers moyens d'évaluation 330 dudit $i^{ème}$ coefficient de fiabilité c$_i$ de la $i^{ème}$ séquence de K éléments binaires S$_i$ à partir dudit $i^{ème}$ nombre d'occurrences No$_i$.

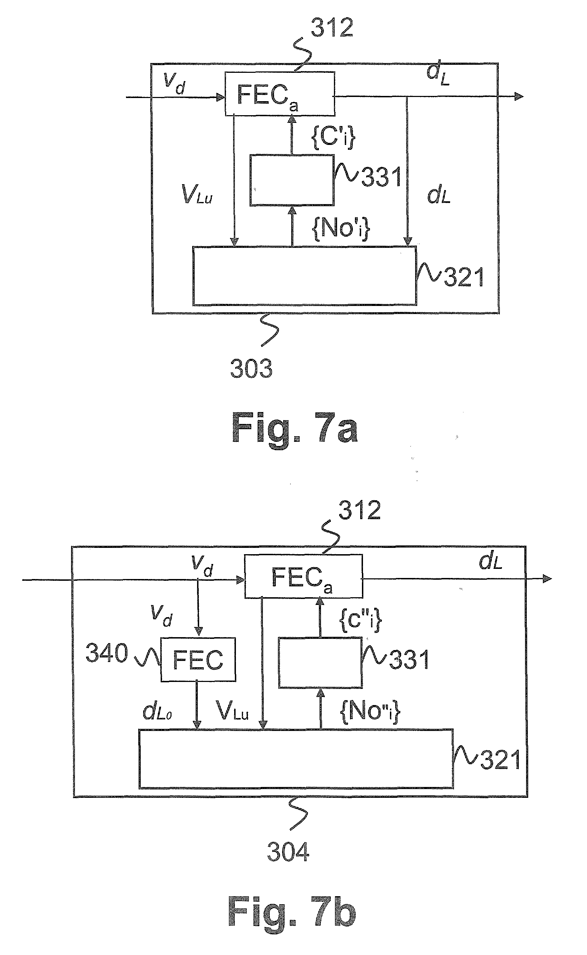

En référence à la Fig. 7a, on présente un dispositif de décodage 303 selon un troisième mode de réalisation de l'invention. Un tel dispositif de décodage comprend :

- le décodeur FECa,
- des seconds moyens de comptage 321 d'un $i^{ème}$ nombre d'occurrences No'$_i$ de la $i^{ème}$ séquence de K éléments binaires S$_i$ dans le signal décidé, $0 \leq i \leq 2^K$ -1, telles que le $k^{ème}$ élément binaire diffère de celui de la séquence correspondante du signal décodé, et
- des seconds moyens d'évaluation 331 dudit $i^{ème}$ coefficient de fiabilité c'$_i$ de la $i^{ème}$ séquence de K éléments binaires S$_i$ à partir dudit $i^{ème}$ nombre d'occurrences No'$_i$.

En référence à la Fig. 7b, on présente un dispositif de décodage 304 selon un quatrième mode de réalisation de l'invention. Un tel dispositif comprend un deuxième décodeur FEC, 340 apte à décoder le signal décidé en un signal décodé intermédiaire, ledit signal décodé intermédiaire étant destiné à être fourni aux seconds moyens de comptage 321.

Pour illustrer l'invention, on considère maintenant un exemple simple de code correcteur d'erreurs, le code par répétition triple. Lorsqu'on utilise un tel code:

- pour transmettre *0,* la séquence '0 0 0' est émise;
- pour transmettre *1,* la séquence '1 1 1' est émise.

Lorsqu'on utilise un décodeur FEC classique mettant en oeuvre la distance de Hamming sur un canal binaire symétrique, les séquences reçues donnent les informations décodées relevées dans le tableau 1 ci-dessous :

*Tableau 1*

| Décidé | 000 | 001 | 010 | 011 | 100 | 101 | 110 | 111 |
|---|---|---|---|---|---|---|---|---|
| Distance de 000 | 0 | 1 | 1 | 2 | 1 | 2 | 2 | 3 |
| Distance de 111 | 3 | 2 | 2 | 1 | 2 | 1 | 1 | 0 |
| *Sortie décodeur* | *0* | *0* | *0* | *1* | *0* | *1* | *1* | *1* |

Lorsqu'on utilise le dispositif de décodage selon l'invention avec l'hypothèse que les 1 sont beaucoup moins fiables que les 0 (situation typique d'un seuil de décision trop bas), on obtient en sortie les informations décodées relevées dans le tableau 2 suivant:

| | Décidé | 000 | 001 | 010 | 011 | 100 | 101 | 110 | 111 |
|---|---|---|---|---|---|---|---|---|---|
| Pseudo Distance d | de 000 | 0 | $c_1$ | $c_1$ | $2\,c_1$ | $c_1$ | $2\,c_1$ | $2\,c_1$ | $3\,c_1$ |
| | de 111 | $3\,c_2$ | $2\,c_2$ | $2\,c_2$ | $c_2$ | $2\,c_2$ | $c_2$ | $c_2$ | 0 |
| | de 000 | 0 | 0.3 | 0.3 | 0.6 | 0.3 | 0.6 | 0.6 | 0.9 |
| | de 111 | 2.1 | 1.4 | 1.4 | 0.7 | 1.4 | 0.7 | 0.7 | 0 |
| | Sortie décodeur | 0 | 0 | 0 | 0 | 0 | 0 | 0 | 1 |

Où $c_1 = 0.3$ et $c_2 = 0.7$

*Tableau 2*

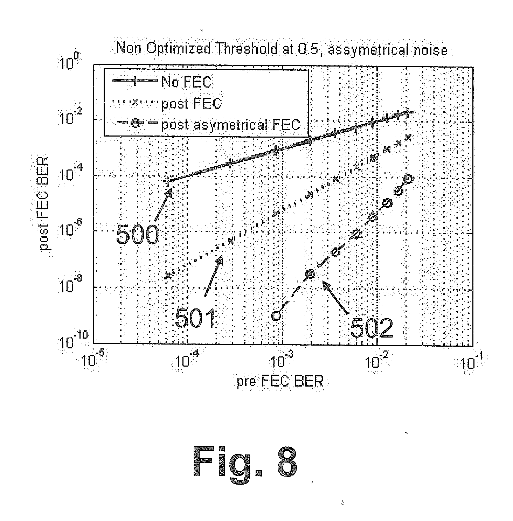

En référence à la Fig. 8, on présente une série de courbes 500, 501, 502 simulées à partir de l'exemple précédent. Un canal binaire non symétrique est émulé par un canal utilisant un seuil non optimal. La courbe 500 représente la probabilité d'erreur en sortie d'un décodeur qui ne met pas en oeuvre de code correcteur d'erreurs; la courbe 501 représente la probabilité d'erreur en sortie d'un décodeur FEC classique et la courbe 502 représente la probabilité d'erreur en sortie d'un dispositif de décodage selon l'invention. De telles courbes permettent de comparer les variations de performances de dispositifs de décodage selon l'invention et selon l'art antérieur en fonction de la probabilité d'erreur en entrée dans le dispositif de décodage.

Elles montrent que la mise en oeuvre du procédé de décodage selon l'invention dans un système de transmission permet, en prenant en compte la fiabilité différente des 0 et des 1, d'améliorer significativement le taux d'erreur de sortie.

**Revendications**

1. Procédé de décodage d'un signal décidé ($V_d$) reçu d'un circuit de décision (210) en un signal décodé ($d_L$), ledit procédé comprenant:

   - une étape (10) de détection d'un mot de N éléments binaires ($V_{Nd}$) dans ledit signal décidé reçu ($V_d$),
   - une étape de sélection (20) d'un mot admissible ($W_{Na}$) de N éléments binaires dans un dictionnaire du code correcteur d'erreur mis en oeuvre à l'encodage, selon un critère de plus courte distance entre ledit mot détecté ($V_{Nd}$) et ledit mot admissible sélectionné ($W_{Na}$),
   - une étape de décodage (30) destinée à fournir un mot de L éléments binaires constituant ledit signal décodé ($d_L$) à partir dudit mot admissible sélectionné ($W_{Na}$),

   **caractérisé en ce que** la distance mise en oeuvre dans l'étape de sélection prend en compte des fiabilités relatives de $2^K$ séquences de K éléments binaires, 0<K<N.

2. Procédé de décodage selon la revendication 1, **caractérisé en ce que** ladite distance est une somme pondérée de $2^K$ cardinaux, dans laquelle le $i^{ème}$ cardinal, $0 \le i \le 2^K -1$, comptabilisant des occurrences de la $i^{ème}$ séquence de K éléments binaires dans le mot détecté ($V_{Nd}$), telles que le $k^{ème}$ élément binaire, $0 \le k \le K -1$, de la $i^{ème}$ séquence de K éléments binaires diffère de celui de la séquence correspondante dans le mot admissible sélectionné ($W_{Na}$), est pondéré par un $i^{ème}$ coefficient de fiabilité ($c_i$) de ladite $i^{ème}$ séquence de K éléments binaires.

3. Procédé de décodage selon la revendication 2, **caractérisé en ce que** lesdits coefficients de fiabilité ($c_i$) sont déterminés au préalable.

4. Procédé de décodage selon la revendication 2, **caractérisé en ce qu'**il comprend:

- une étape (40) de suppression d'une séquence de N-L éléments binaires redondants dans le mot détecté ($V_{Nd}$), destinée à fournir un mot détecté utile ($V_{Lu}$) constitué d'éléments binaires d'information,
- une première étape de comptage (50) d'un i$^{\text{ème}}$ nombre d'occurrences $No_i$ de la i$^{\text{ème}}$ séquence $S_i$, $0 \leq i \leq 2^K$ -1 de K éléments binaires dans les mots détectés utiles ($\{V_{Lu}(t)\}$) pendant un intervalle de temps T déterminé,
- une première étape (60) d'évaluation dudit i$^{\text{ème}}$ coefficient de fiabilité ($c_i$) de la i$^{\text{ème}}$ séquence de K éléments binaires ($S_i$) à partir dudit i$^{\text{ème}}$ nombre d'occurrences $No_i$.

**5.** Procédé de décodage selon la revendication 2, **caractérisé en ce qu'**il comprend:

- une étape (40) de suppression d'une séquence de N-L éléments binaires redondants dans le mot détecté ($V_{Nd}$), destinée à fournir un mot détecté utile ($V_{Lu}$) constitué d'éléments binaires d'information;
- une seconde étape (51) de comptage d'un i$^{\text{ème}}$ cardinal d'occurrences $No'_i$ de la séquence $S_i$, $0 \leq i \leq 2^K$ -1 , de K éléments binaires dans les mots détectés utiles ($\{V_{Lu}(t)\}$) pendant un intervalle de temps T déterminé, telles que le k$^{\text{ème}}$ élément binaire diffère de celui de la séquence correspondante dans le signal décodé ($d_L$), et
- une seconde étape (61) d'évaluation dudit i$^{\text{ème}}$ coefficient de fiabilité $c'_i$ de la i$^{\text{ème}}$ séquence de K éléments binaires $S_i$ à partir dudit i$^{\text{ème}}$ nombre d'occurrences $No'_i$.

**6.** Procédé de décodage selon l'une des revendications 4 et 5, **caractérisé en ce que** lesdites étapes (51, 61) de comptage et d'évaluation sont répétées régulièrement dans le temps.

**7.** Procédé de décodage selon l'une des revendications 5 et 6, **caractérisé en ce qu'**il comprend:

- une deuxième étape (21) de sélection d'un mot admissible intermédiaire ($W_{Na0}$) comprenant N éléments binaires dans ledit dictionnaire du code correcteur d'erreurs selon un critère de plus courte distance entre ledit mot détecté ($V_{Nd}$) et ledit mot admissible intermédiaire, à partir d'une seconde distance égale au cardinal des occurrences de séquences de K éléments binaires $S_i$ présentes dans le signal décidé, $0 \leq i \leq 2^K$ -1 , telles que le k$^{\text{ème}}$ élément binaire diffère de celui de la séquence correspondante dans le mot admissible intermédiaire ($W_{Na0}$),
- une deuxième étape de décodage (31) d'un mot de K éléments binaires constituant un signal décodé intermédiaire ($d_{L0}$) à partir dudit mot admissible intermédiaire ($W_{Na0}$), ledit signal décodé intermédiaire étant destiné à être fourni à ladite seconde étape de comptage (51).

**8.** Décodeur ($FEC_a$, 310) d'un signal décidé (Vd) reçu d'un circuit de décision (210) en un signal décodé ($d_L$), ledit décodeur comprenant :

- des moyens de détection d'un mot de N éléments binaires dans ledit signal décidé reçu, aptes à fournir un mot détecté ($V_{Nd}$),
- des moyens de sélection d'un mot admissible ($W_{Na}$) de N éléments binaires dans un dictionnaire du code correcteur d'erreurs utilisé à l'encodage selon un critère de plus courte distance entre ledit mot détecté et ledit mot admissible sélectionné,
- des moyens de décodage d'un mot de L éléments binaires constituant ledit signal décodé ($d_L$) à partir dudit mot admissible sélectionné ($W_{Na}$),

**caractérisé en ce que** la distance mise en oeuvre par lesdits moyens de sélection est adaptée pour prendre en compte des fiabilités relatives de $2^K$ séquences de L éléments binaires, 0<L<N.

**9.** Dispositif de décodage (300) comprenant le décodeur ($FEC_a$, 310) selon la revendication 8, ledit décodeur comprenant des moyens de suppression d'une séquence de N-L éléments binaires redondants dans le mot détecté, destinée à fournir un mot détecté utile ($V_{Lu}$) constitué d'éléments binaires d'information, ledit dispositif étant **caractérisé en ce qu'**il comprend :

- des premiers moyens de comptage (320) d'un i$^{\text{ème}}$ nombre d'occurrences $No_i$ de la i$^{\text{ème}}$ séquence de K éléments binaires $S_i$, $0 \leq i \leq 2^K$ -1, dans les mots détectés utiles ($V_{Lu}$) pendant un intervalle de temps T déterminé,
- des premiers moyens d'évaluation (330) dudit i$^{\text{ème}}$ coefficient de fiabilité $c_i$ de la i$^{\text{ème}}$ séquence de K éléments binaires $S_i$ à partir dudit i$^{\text{ème}}$ nombre d'occurrences $No_i$,

**10.** Dispositif de décodage (301) comprenant le décodeur (FECa) selon la revendication 8, ledit décodeur comprenant des moyens de suppression d'une séquence de N-L éléments binaires redondants dans le mot détecté, 0<L<N, destinée à fournir un mot détecté utile ($V_{Lu}$) constitué d'éléments binaires d'information, **caractérisé en ce que** ledit dispositif comprend :

- des seconds moyens de comptage (321) d'un $i^{ème}$ nombre d'occurrences $No'_i$ de la $i^{ème}$ séquence de K éléments binaires $S_k$ dans le mot détecté utile ($V_{Lu}$), $0 \le i \le 2^K - 1$, telles que le $k^{ème}$ élément binaire diffère de celui de la séquence correspondante du signal décodé ($d_L$);
- des seconds moyens d'évaluation (331) dudit $i^{ème}$ coefficient de fiabilité $c'_i$ de la $i^{ème}$ séquence de K éléments binaires $S_k$ à partir dudit $i^{ème}$ nombre d'occurrences $No'_i$.

**11.** Dispositif de décodage (302) selon la revendication 10, **caractérisé en ce qu'**il comprend un deuxième décodeur (FEC, 340) apte à décoder le signal décidé ($V_d$) en un signal décodé intermédiaire ($d_{L0}$), ledit signal décodé intermédiaire étant destiné à être fourni aux seconds moyens de comptage (321).

**12.** Récepteur (400) comprenant un circuit de décision (210) apte à fournir un signal décidé ($V_d$) à partir d'un signal transmis ($V_t$) et un décodeur ($FEC_a$) apte à décoder ledit signal décidé ($V_d$), ledit décodeur comprenant :

- des moyens de détection d'un mot de N éléments binaires dans ledit signal décidé reçu, aptes à fournir un mot détecté ($V_{Nd}$),
- des moyens de sélection d'un mot admissible ($W_{Na}$) de N éléments binaires dans un dictionnaire de codes correcteurs d'erreurs selon un critère de plus courte distance entre ledit mot détecté et ledit mot admissible sélectionné,
- des moyens de décodage d'un mot de L éléments binaires constituant ledit signal décodé ($d_L$) à partir dudit mot admissible sélectionné,

**caractérisé en ce que** la distance mise en oeuvre par lesdits moyens de sélection est adaptée pour prendre en compte des fiabilités relatives de $2^K$ séquences de K éléments binaires, $0<K<N$.

**13.** Produit programme d'ordinateur téléchargeable depuis un réseau de communication et/ou stocké sur un support lisible par ordinateur et/ou exécutable par un microprocesseur, **caractérisé en ce qu'**il comprend des instructions de code de programme pour l'exécution du procédé de décodage selon l'une au moins des revendications 1 à 7, lorsqu'il est exécuté sur un ordinateur.

Fig. 1a

Fig. 1b

$V_d$

10

$V_{Nd}$

20

$C_i$

$W_{Na}$

30

$d_L$

# Fig. 2

**Fig. 3**

Fig. 4

**Fig. 5**

312

$v_d \longrightarrow$ FEC$_a$ $\longrightarrow d_L$

$\{c_i\}$

# Fig. 6a

400

312

$V_t \longrightarrow$ [210] $\longrightarrow v_d \longrightarrow$ FEC$_a$ $\longrightarrow d_L$

$\{C_i\}$

330

$V_{Lu}$

$\{No_i\}$

320

302

# Fig. 6b

**Fig. 7a**

**Fig. 7b**

Fig. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **T. MIZUOCHI.** *Next Generation FEC (''Forward Error Coding'') for Optical Transmission Systems*

- **RON ROTH.** Introduction to Coding Theory